# EUROPEAN PATENT SPECIFICATION

(11) **EP 2 899 764 B1**
(45) Date of publication and mention of the grant of the patent: **07.03.2018**
(21) Application number: 15151930.3
(22) Date of filing: 21.01.2015
(51) Int. Cl.: H01L 35/32, H01L 35/30

(54) **Thermoelectric module and heat conversion device including the same**
Thermoelektrisches Modul und Wärmeumwandlungsvorrichtung damit
Module thermoélectrique et dispositif de conversion de chaleur l'utilisant

(30) Priority: 23.01.2014 KR 20140008429
(43) Date of publication of application: 29.07.2015
(73) Proprietor: LG Innotek Co., Ltd., Seoul, 04637 (KR)
(72) Inventor: Won, Boone, 100-714 SEOUL (KR); Kim, Sang Gon, 100-714 SEOUL (KR)
(74) Representative: Novagraaf Technologies

(56) References cited:
- JP-A- 2005 093 532
- JP-A- 2009 164 498
- US-A1- 2010 229 911
- US-A1- 2012 049 315
- US-A1- 2012 145 215

## Description

### BACKGROUND OF THE INVENTION

### Field of the Invention

Embodiments of the present invention relate to a thermoelectric module used for a cooling purpose.

### Description of the Related Arts

Generally, a thermoelectric element including thermoelectric converting elements is configured such that a P-type thermoelectric material and an N-type thermoelectric material are bonded between metal electrodes to form a PN bonding pair.

When a temperature difference is applied to the PN bonding pair, electric power is produced by a Seeback effect so that the thermoelectric element can serve as a power generation device. Furthermore, the thermoelectric element may be used as a temperature control device by a Peltier effect that one part of the PN bonding pair is cooled and the other part thereof is heated.

Here, the Peltier effect refers to a phenomenon in which a p-type material hole and an N-type material electron are moved when an external DC voltage is applied thereto, thereby causing heat or heat absorption from both ends of the material. The Seebeck effect refers to a phenomenon in which the hole and the electron are moved when heat is supplied from an external heat source so that current can flow through the material, thereby causing electric power.

Active cooling using such a thermoelectric material has been recognized as a friendly environment method because the active cooling can improve thermal stability of the thermoelectric element, does not cause noise and vibration, and does not use a separate condenser and refrigerant, thereby accommodating a small amount of space. The application fields for the active cooling using the thermoelectric material refer to a non-refrigerant refrigerator, an air conditioner, various micro-cooling systems, or the like. In particular, when the thermoelectric element is attached to various memory elements, the thermoelectric element can be maintained in a uniform and stable temperature with a reduction in a volume compared to that using the existing cooling method, thereby enabling the improvement of performance of the thermoelectric element.

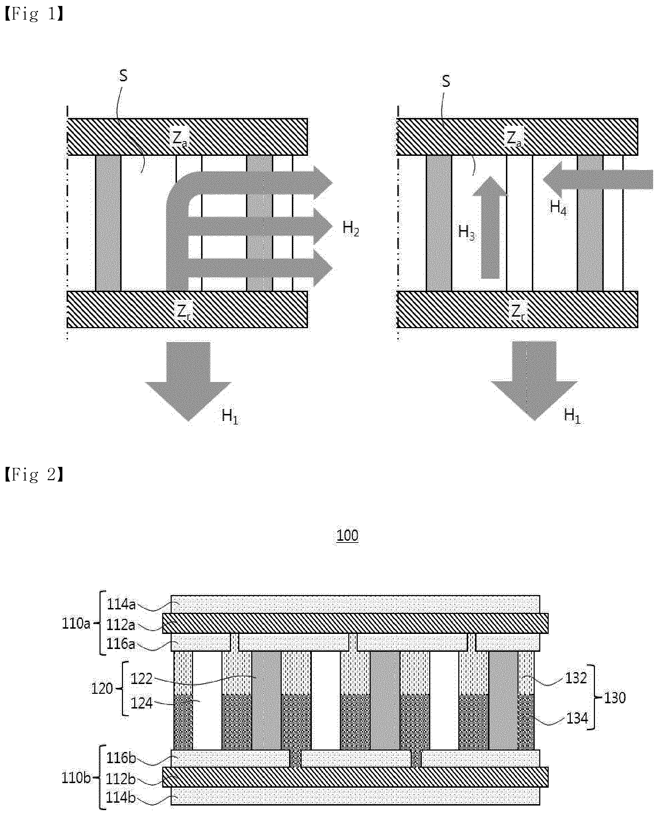

Sealing for a unit module composed of an N-type semiconductor element and a P-type semiconductor element is performed with insulating resin upon manufacturing a thermoelectric module. This is intended to realize waterproof and insulation by blocking exposure to the outside. However, when the same sealing material is used in the module, heat build-up is generated inside the elements so that cooling efficiency can be reduced. Referring to FIG. 1, when one kind of the sealing material S is used in the module, heat H₂ generated from a heating part Zᵣ is emitted via a sealing portion and a thermoelectric element adjacent to a heat absorbing part Zₐ as well as via a lower substrate of the heating part Zᵣ. Also, the heat H₃ generated from the heating part Zᵣ is directly transmitted to the heat absorbing part Zₐ, or heat H₄ of the outside is transmitted to the heat absorbing part, thereby causing the reduction of cooling performance.

US2012/0049315 describes a thermoelectric module having two substrates arranged and separated to face each other, with thermoelectric elements arranged between the substrates and a hybrid filler filling the spaces between the thermoelectric elements.

### SUMMARY OF THE INVENTION

The present invention has been made keeping in mind the above problems, an aspect of embodiments of the present invention provides a thermoelectric module, in accordance with claim 1 including:
a first substrate and a second substrate disposed to face each other; at least one unit thermoelectric element composed of a pair of semiconductor elements including a P-type semiconductor element and an N-type semiconductor element disposed in an internal area between the first substrate and the second substrate disposed to face each other and having respective ends electrically connected to each other via electrodes; and at least two kinds of sealing parts having different thermal conductivities and coated on at least one area of the internal area between the first substrate and the second substrate disposed to face each other.

Also, according to another aspect of embodiments of the present invention, there is provided a heat conversion device including the thermoelectric module, in accordance with claim 13.

### BRIEF DESCRIPTION OF THE DRAWINGS

The accompanying drawings are included to provide a further understanding of the present invention, and are incorporated in and constitute a part of this specification. The drawings illustrate exemplary embodiments of the present invention and, together with the description, serve to explain principles of the present invention. In the drawings:
FIG. 1 is a mimetic diagram showing heat transfer of a conventional thermoelectric module;
FIG. 2 is an exemplary cross-sectional view of a thermoelectric module according to an embodiment of the present invention;
FIG. 3 is an exemplary perspective view of the thermoelectric module according to the embodiment of the present invention; and
FIG. 4 is a mimetic diagram showing heat transfer of the thermoelectric module according to the embodiment of the present invention.

### DETAILED DESCRIPTION OF THE INVENTION

Hereinafter, the configurations and operations according to embodiments of the present invention will be described in detail with reference to the accompanying drawings. The present invention may, however, be embodied in different forms and should not be construed as limited to the embodiments set forth herein. In the explanation with reference to the accompanying drawings, regardless of reference numerals of the drawings, like numbers refer to like elements through the specification, and repeated explanation thereon is omitted. Terms such as a first term and a second term may be used for explaining various constitutive elements, but the constitutive elements should not be limited to these terms. These terms are only used for the purpose for distinguishing a constitutive element from other constitutive element. As used herein, the singular forms "a," "an" and "the" are intended to include the plural forms as well, unless the context clearly indicates otherwise.

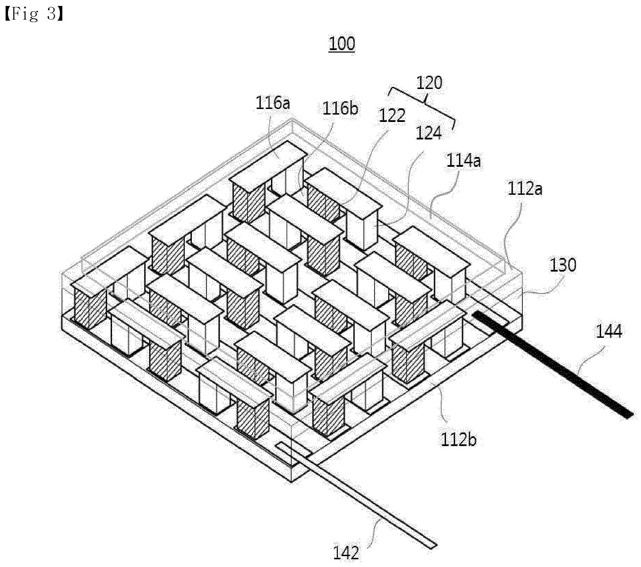

FIG. 2 is an exemplary cross-sectional view of a thermoelectric module according to an embodiment of the present invention, and FIG. 3 is an exemplary perspective view of the thermoelectric module according to the embodiment of the present invention.

A thermoelectric module 100 according to the present embodiment of the invention may include: a first substrate 110a and a second substrate 110b disposed to face each other; at least one unit thermoelectric element composed of a pair of semiconductor elements 120; and at least two kinds of sealing parts 130 having different thermal conductivities and coated on at least one area of the thermoelectric module.

In particular, the sealing part 130 may be partially or entirely filled in an internal area between the first substrate 110a and the second substrate 110b disposed to face each other. The sealing part 130 is intended for waterproof and insulation by blocking exposure to the outside. The sealing part 130 is composed of an insulator. Epoxy resin, silicon resin, acrylic resin, Teflon resin, mica or the like may be used as the insulator. In the thermoelectric module according to the present embodiment, any one of the first substrate 110a and the second substrate 110b serves as a heat generating area (a heating part) and another one thereof serves as a heat absorbing area (a heat absorbing part). In order to prevent heat emitted from the heating part from flowing into the heat absorbing part, a sealing part 134 in contact with the heating part and a sealing part 132 in contact with the heat absorbing part are composed of two sealing materials having different thermal conductivities. Thus, thanks to insulation from the outside, cool air may be completely concentrated in a cooling part. Further, heat generated from the heating part is locally emitted around the heating part so that heat transfer to the heat absorbing part can be minimized, thereby enabling the improvement of cooling efficiency.

To do so, in the present embodiment of the invention, the sealing part includes at least two kinds of sealing parts coated on at least one area of the internal area between the first substrate and the second substrate disposed to face each other. As one example, as illustrated in FIG. 2, the sealing part may be implemented in a double layered structure. The sealing part 130 may include: the first sealing part 132 in contact with one surface of the first substrate 110a; and the second sealing part 134 in contact with one surface of the second substrate 110b and disposed to be in contact with at least one area of the first sealing part 132.

In particular, in the structure in which the first substrate 110a serves as the heat absorbing part, and the second substrate 110b serves as the heating part, the first sealing part 132 may be made of a material having a lower thermal conductivity than that of the second sealing part 134. This is intended to prevent heat emitted from the heating part from flowing into the heat absorbing part and to enable the heat of the heating part to be easily emitted to the outside.

For a more efficient structure, in the structure illustrated in FIG. 2, the first sealing part and the second sealing part are formed to have substantially the same volume. However, in order to increase radiant heat or heat absorbing efficiency, a volume of the first sealing part and a volume of the second sealing part may be adjusted such that the first and second sealing part have different volumes.

In the case of a cooling thermoelectric module, a general insulating substrate such as an alumina substrate may be used as the first substrate 110a and the second substrate 110b. Also, as another example, the first substrate 110a and the second substrate 110b may include ceramic substrate layers 112a, 112b, respectively. In such a case, the ceramic substrate layer may be an insulating material such as Al₂O₃, AlN, Si₃N₄ or BeO, or the like. Moreover, each thickness of the ceramic substrate layers 112a, 112b ranges from 0.1 to 1 mm. When each thickness of the ceramic substrate layers 112a, 112b is less than 0.1 mm, a defect and current flow may be caused because strength of the first substrate 110a and the second substrate 110b lacks. On the contrary, when each thickness thereof is more than 1 mm, a weight of the thermoelectric module is increased in terms of the properties of a ceramic material, Thus, it is not desirable for each thickness to deviate from the range.

Also, the first substrate 110a and the second substrate 110b may be DBC (Direct Bond Copper) substrates. Both surfaces of the DBC substrate are subjected to bonding treatment with copper so as to enable soldering or wiring bonding. As shown in FIG. 2, a general structure of the DBC substrate is configured such that upper metal layers 114a, 114b are bonded to respective upper surfaces of the ceramic substrate layers 112a, 112b corresponding to insulating substrates, and lower metal layers 116a, 116b are bonded to respective lower surfaces of the ceramic substrate layers 112a, 112b. Here, "the upper metal layers" refer to metal layers bonded to respective external sides of the thermoelectric module 100 based on the first substrate 110a and the second substrate 110b, and "the lower metal layers" refer to metal layers bonded to respective internal sides of the thermoelectric module 100, namely, metal layers bonded to the semiconductor elements 120.

The upper metal layers 114a, 114b are formed on respective entire surfaces or respective partial surfaces of the ceramic substrate layers using a chemical vapor deposition (CVD) method, an evaporator, a sputtering method, a directly compression method of the metal layers, or the like. Each thickness of the upper metal layers 114a, 114b ranges from 50 to 500 *µ*m.

The lower metal layers 116a, 116b may be formed on respective one surfaces and respective another surfaces of the ceramic substrate layers 112a, 112b, namely, opposing surfaces of the ceramic substrate layers 112a, 112b. Like the method of forming the upper metal layers 114a, 114b, the lower metal layers are formed on respective entire surfaces or respective partial surfaces of the ceramic substrate layers using a chemical vapor deposition (CVD) method, an evaporator, a sputtering method, a directly compression method of the metal layers, or the like. Since the lower metal layers 116a, 116b are bonded to the semiconductor elements 120 so as to be electrodes of the semiconductor elements, the lower metal layers may be appropriately patterned according to a form and arrangement of the semiconductor elements. Each thickness of the lower metal layers 116, 116b ranges from 50 to 500 *µ*m. In particular, the lower metal layers may be applied as electrodes. When the lower metal layers are implemented as electrode layers, the upper metal layers may be omitted. The upper metal layers may serve as electrode layers for electrically connecting the first semiconductor element and the second semiconductor element using an electrode material such as Cu, Ag, Ni and the like, and each thickness of the electrode layers ranges from 0.01 to 0.3 mm.

Moreover, in the case of another example, the first substrate or the second substrate may be composed of a metal substrate. That is, by using the metal substrate, radiant heat efficiency and a slimming structure may be implemented. Of course, when the first substrate or the second substrate is formed as the metal substrate, a dielectric layer may be formed between the electrode layers formed on the first substrate and the second substrate. In the case of the metal substrate, Cu or a Cu alloy, a Cu-Al alloy, or the like may be applied as a material of the metal substrate. A thickness of the metal substrate may range from 0.1 to 0.5 mm so that a slimming structure can be ensured. Also, the dielectric layer is made of a dielectric material having a high radiant heat ability. In consideration of a thermal conductivity of the cooling thermoelectric module, a material having a thermal conductivity of 5∼10 W/K may be used as a material of the dielectric layer, and a thickness of the dielectric layer may range from 0.01 to 0.1 mm.

In the present embodiment, a semiconductor element formed in a bulk type by applying a P-type semiconductor material or an N-type semiconductor material may be applied as the semiconductor element 120. The bulk type refers to a structure formed by pulverizing an ingot corresponding to a semiconductor material and subjecting the pulverized ingot to a refining ball mill process to obtain a sintered structure and by cutting the sintered structure. Such a bulk-type structure may be formed in one integral structure. The P-type semiconductor element 122 or 124, or the N-type semiconductor element 122 or 124 may be a Bi-Te-based semiconductor element.

The N-type semiconductor element 122 or 124 may be formed using a main raw material based on Bi-Te including Se, Ni, Al, Cu, Ag, Pb, B, Ga, Te, Bi, and In, and a mixture in which 0.001 to 1.0 wt% of Bi or Te based on the total weight of the main raw material is mixed. For example, when a Bi-Se-Te material is used as a main raw material, Bi or Te may be additionally mixed in an amount of 0.001 to 1.0 wt% based on the total weight of the Bi-Se-Te material. That is, when an amount of the Bi-Se-Te material is 100 g, additionally mixed Bi or Te may be added in an amount ranging from 0.001 to 1.0 g. As described above, when the amount of a material added to the main raw material is beyond the range from 0.001 to 0.1 wt%, thermal conductivity is not reduced, and electrical conductivity is decreased, so the improvement of a ZT value may not be expected. In light of this fact, the range has a meaning.

The P-type semiconductor element 122 or 124 may be formed using a main raw material based on Bi-Te including Se, Ni, Al, Cu, Ag, Pb, B, Ga, Te, Bi, and In, and a mixture in which 0.001 to 1.0 wt% of Bi or Te based on the total weight of the main raw material is mixed. For example, when a Bi-Se-Te material is used as a main raw material, Bi or Te may be additionally mixed in an amount of 0.001 to 1.0 wt% based on the total weight of the Bi-Se-Te material. That is, when an amount of the Bi-Se-Te material is 100 g, additionally mixed Bi or Te may be added in an amount ranging from 0.001 to 1.0 g. As described above, when the amount of a material added to the main raw material is beyond the range from 0.001 to 0.1 wt%, thermal conductivity is not reduced, and electrical conductivity is decreased, so the improvement of a ZT value may not be expected. In light of this fact, the range has a meaning.

The thermoelectric module according to the present embodiment may be configured such that semiconductor elements 130 having different materials and properties may be arranged to make a pair, and the respective semiconductor elements 120 in pairs may be configured such that a plurality of unit thermoelectric elements electrically connected by the metal electrode is arranged. In particular, in such a case, with regard to the thermoelectric elements constituting the unit thermoelectric elements, each one side thereof may be composed of the P-type semiconductor element 122 or 124 and each another side thereof may be composed of the N-type semiconductor element 122 or 124. The P-type semiconductor element 122 or 124 and the N-type semiconductor element 122 or 124 are connected to the lower metal layers 116a, 116b, respectively. Such a structure is formed in plural numbers, and a Peltier effect is implemented by circuit lines 142, 144 for supplying a current to the semiconductor elements via electrodes.

Hereinafter, a modified embodiment of another configuration applied to the thermoelectric module having the sealing part according to the embodiment of the present invention of FIGS. 2 and 3 will be described.

In the present embodiment of the invention, the second substrate 110b is formed to have an area in a 1.2 to 5 folds increase compared to an area of the first substrate 110a so that the first substrate and the second substrate can be formed to have different volumes. That is, a width of the first substrate 110a is formed narrower than that of the second substrate 110b. In such a case, the substrates having the same thickness are formed to have different areas so that the respective volumes can be changed. When the area of the second substrate 110b is formed to be less than a 1.2 folds increase compared to that of the first substrate 110a, there is no large difference with existing heat conduction efficiency, and accordingly, a slimming structure becomes meaningless. Meanwhile, when the area of the second substrate 110b is formed to be more than a 5 folds increase compared to that of the first substrate 110a, it is difficult to maintain a form (for example, an opposing structure) of thermoelectric module, and heat transfer efficiency is remarkably reduced.

Moreover, in the case of the second substrate 110b, radiant heat patterns such as uneven patterns are formed on a surface of the second substrate so that a radiant heat property of the second substrate can be maximized. Thanks to such a configuration, even though the element of an existing heat sink is not used, the radiant heat property may be effectively ensured. In this case, the radiant heat patterns may be formed on one side or both sides of the surface of the second substrate. In particular, when the radiant heat patterns are formed on a surface that comes into contact with the first and second semiconductor elements, a radiant heat property and a bonding property between the thermoelectric element and the substrate can be increased.

Also, a thickness of the first substrate 110a is formed thinner than that of the second substrate 110b so that the inflow of heat into a cooling part can be easily performed and a heat transfer coefficient can be increased.

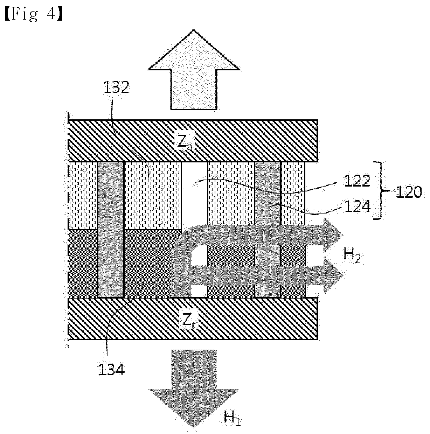

FIG. 4 is a mimetic diagram showing heat transfer of the thermoelectric module according to the embodiment of the present invention.

Referring to FIG. 4, the sealing parts 132, 134 are different kinds of insulators having different thermal conductivities that are filled in a top half area and a bottom half area of the unit thermoelectric elements. In order to prevent the heat H₂ emitted from the heating part Zᵣ from flowing into the heat absorbing part Zₐ, the sealing part 134 in contact with the heating part Zᵣ and the sealing part 132 in contact with the heat absorbing part Zₐ may be formed using two different kinds of sealing materials having different thermal conductivities.

At this time, a sealing material having a high thermal conductivity is used in the heating part Zᵣ so that emission of the heat H₁, H₂ can be mostly introduced to the heating part Zᵣ. On the contrary, a sealing material having a low thermal conductivity is used in the heat absorbing part Zₐ so that the heat from the outside of the thermoelectric element to a cooling portion and the heat emitted from the heating part Zᵣ can block the heat flowing into the heat absorbing part Zₐ. The thermal conductivity may be changed according to the kind, viscosity, density or the like of the insulators. At least two insulators may be used in a state of being mixed.

A cooling device according to another aspect of the present embodiment includes a thermoelectric module, including: a first substrate and a second substrate disposed to face each other; at least one unit thermoelectric element composed of a pair of semiconductor elements including a P-type semiconductor element and an N-type semiconductor element disposed in an internal area between the first substrate and the second substrate disposed to face each other and having respective ends electrically connected to each other via electrodes; and at least two kinds of sealing parts having different thermal conductivities and coated on at least one area of the internal area between the first substrate and the second substrate disposed to face each other.

The thermoelectric elements various structures according to the embodiment of the present invention and the thermoelectric module including the thermoelectric elements may enable cooling of the surfaces of the upper and lower substrates by reducing the heat of a medium such as water or a liquid according to the properties of the heating part and the heat absorbing part, or may be used for a heating purpose by transmitting heat to a specific medium. That is, with regard to the thermoelectric module according to various embodiments of the present invention, the configuration of a cooling device implemented by increasing cooling efficiency has been explained as an embodiment. However, in the substrate of an opposing surface in which cooling is performed, the thermoelectric module may be applied as a device used for heating a medium using a radiant heat property. That is, the thermoelectric module may be applied as a device that enables cooling and heating to be simultaneously implemented in one device.

As set forth above, according to some embodiments of the present invention, the sealing parts arranged between the substrates facing each other are implemented in layers made of different materials having different thermal conductivities so that cool air can be completely concentrated in the cooling part thanks to insulation from the outside. Furthermore, heat generated from the heating part is locally emitted around the heating part so that heat transfer to the heat absorbing part can be minimized, thereby enabling the improvement of cooling efficiency.

As previously described, in the detailed description of the invention, having described the detailed exemplary embodiments of the invention, it should be apparent that modifications and variations can be made by persons skilled without deviating from the scope of the invention. Therefore, it is to be understood that the foregoing is illustrative of the present invention and is not to be construed as limited to the specific embodiments disclosed, and that modifications to the disclosed embodiments, as well as other embodiments, are intended to be included within the scope of the appended claims.

## Claims

1. A thermoelectric module (100), comprising:
a first substrate (110a) and a second substrate (110b) disposed to face each other;
a unit thermoelectric element disposed in an internal area between the first substrate (110a) and the second substrate (110b) disposed to face each other and including a pair of semiconductor elements (122 ; 124) electrically connected to each other; and
at least two kinds of sealing parts (132 ; 134) having different thermal conductivities and disposed in the internal area, and
wherein the two kinds of sealing parts (132 ; 134) are composed of an insulator, **characterised in that** the first substrate (110a) has a first Cu layer (114a) and a second Cu layer (116a) in which a first ceramic substrate layer (112a) is interposed between the first Cu layer (114a) and the second Cu layer (116a),
wherein the second substrate (110b) has a third Cu layer (116b) and a fourth Cu layer (114b) in which a second ceramic substrate layer (112b) is interposed between the third Cu layer (116b) and the fourth Cu layers (114b),
wherein each thickness of the first and second ceramic substrate layers (112a, 112b) ranges from 0.1 to 1 mm,
wherein each of the first and fourth Cu layers (114a, 114b) are bounded to external sides of the thermoelectric module and are formed on surfaces of the first and second ceramic substrate layers (112a, 112b) and each thickness of the first and fourth Cu layers (114a, 114b) ranges from 50 to 500 µm,
wherein each of the second and third Cu layers (116a, 116b) are bounded to internal sides of the thermoelectric module and electrically connected to the thermoelectric element and formed on surfaces of the first and second ceramic substrate layers (112a, 112b) and each thickness of the second and third layers (116a, 116b) ranges from 0.01 to 0.3 mm.

2. The thermoelectric module (100) of claim 1, wherein the two kinds of sealing part (130) comprise: a first sealing part (132) in contact with the second Cu layer (116a) and a second sealing part (134) in contact with the third Cu layer(116b) and in contact with of the first sealing part (132).

3. The thermoelectric module (100) of claim 2, wherein the first sealing part (132) is composed of a material having a lower thermal conductivity than that of the second sealing part (134).

4. The thermoelectric module (100) of claim 3, wherein a volume of the first sealing part (132) and a volume of the second sealing part (134) are substantially identical to each other.

5. The thermoelectric module (100) of any one of claims 1 to 4, wherein the first substrate (110a) is a heat absorbing area.

6. The thermoelectric module (100) of any one of claims 1 to 3, wherein the second substrate (110b) is a heating generating area, and a volume of the second sealing part (134) is larger than that of the first sealing part (132).

7. The thermoelectric module (100) of any one of claims 1 to 6, wherein an area of the second substrate (110b) is wider than that of the first substrate (110a).

8. The thermoelectric module (100) of any of claims 1 to 7, wherein the pair of semiconductor elements (120) comprises a first semiconductor element and a second semiconductor element electrically connected to each other.

9. The thermoelectric module (100) of claim 8, wherein the first semiconductor element is a P-type semiconductor element and the second semiconductor element is an N-type semiconductor element.

10. The thermoelectric module (100) of claim 8 or 9, wherein a volume of the second semiconductor element is larger than that of first semiconductor element.

11. The thermoelectric module (100) of any one of claims 1 to 10, wherein a volume of the first substrate (110a) and a volume of the second substrate (110b) are different from each other.

12. The thermoelectric module (100) of any one of claims 1 to 11, further comprising electrode layers on the first substrate (110a) and the second substrate (110b).

13. A heat conversion device including a thermoelectric module (100) according to claim 3.

## Patentansprüche

1. Thermoelektrisches Modul (100), umfassend:
ein erstes Substrat (110a) und ein zweites Substrat (110b), die derart angeordnet sind, dass sie einander zugewandt sind;
ein thermoelektrisches Einheitselement, das in einem Innenbereich zwischen dem ersten Substrat (110a) und dem zweiten Substrat (110b) angeordnet ist, die derart angeordnet sind, dass sie einander zugewandt sind und ein Paar Halbleiterelemente (122; 124) aufweisen, die elektrisch miteinander verbunden sind; und
mindestens zwei Arten von Dichtungsteilen (132; 134) mit unterschiedlichen Wärmeleitfähigkeiten, die im Innenbereich angeordnet sind, und
wobei die zwei Arten von Dichtungsteilen (132; 134) aus einem Isolator zusammengesetzt sind,
**dadurch gekennzeichnet, dass** das erste Substrat (110a) eine erste Cu-Schicht (114a) und eine zweite Cu-Schicht (116a) aufweist, wobei eine erste Keramiksubstratschicht (112a) zwischen der ersten Cu-Schicht (114a) und der zweiten Cu-Schicht (116a) angeordnet ist,
wobei das zweite Substrat (110b) eine dritte Cu-Schicht (116b) und eine vierte Cu-Schicht (114b) aufweist, wobei eine zweite Keramiksubstratschicht (112b) zwischen der dritten Cu-Schicht (116b) und der vierten Cu-Schicht (114b) angeordnet ist,
wobei jede Dicke der ersten und der zweiten Keramiksubstratschicht (112a, 112b) im Bereich von 0,1 bis 1 mm liegt,
wobei jede der ersten und der vierten Cu-Schicht (114a, 114b) an äußere Seiten des thermoelektrischen Moduls gebunden ist und auf Oberflächen der ersten und der zweiten Keramiksubstratschicht (112a, 112b) ausgebildet ist und jede Dicke der ersten und der vierten Cu-Schicht (114a, 114b) im Bereich von 50 bis 500 µm liegt,
wobei jede der zweiten und der dritten Cu-Schicht (116a, 116b) an inneren Seiten des thermoelektrischen Moduls gebunden ist und mit dem thermoelektrischen Element elektrisch verbunden ist und auf Oberflächen der ersten und der zweiten Keramiksubstratschicht (112a, 112b) ausgebildet ist und jede Dicke der zweiten und der dritten Schicht (116a, 116b) im Bereich von 0,01 bis 0,3 mm liegt.

2. Thermoelektrisches Modul (100) nach Anspruch 1, wobei die zwei Arten von Dichtungsteil (130) umfassen: ein erstes Dichtungsteil (132), das mit der zweiten Cu-Schicht (116a) in Kontakt steht, und ein zweites Dichtungsteil (134), das mit der dritten Cu-Schicht (116b) in Kontakt steht und mit dem ersten Dichtungsteil (132) in Kontakt steht.

3. Thermoelektrisches Modul (100) nach Anspruch 2, wobei das erste Dichtungsteil (132) aus einem Material zusammengesetzt ist, das eine geringere Wärmeleitfähigkeit als die des zweiten Dichtungsteils (134) aufweist.

4. Thermoelektrisches Modul (100) nach Anspruch 3, wobei ein Volumen des ersten Dichtungsteils (132) und ein Volumen des zweiten Dichtungsteils (134) im Wesentlichen identisch zueinander sind.

5. Thermoelektrisches Modul (100) nach einem der Ansprüche 1 bis 4, wobei das erste Substrat (110a) ein Wärmeabsorptionsbereich ist.

6. Thermoelektrisches Modul (100) nach einem der Ansprüche 1 bis 3, wobei das zweite Substrat (110b) ein Wärmeerzeugungsbereich ist und ein Volumen des zweiten Dichtungsteils (134) größer als das des ersten Dichtungsteils (132) ist.

7. Thermoelektrisches Modul (100) nach einem der Ansprüche 1 bis 6, wobei ein Bereich des zweiten Substrats (110b) breiter als der des ersten Substrats (110a) ist.

8. Thermoelektrisches Modul (100) nach einem der Ansprüche 1 bis 7, wobei das Paar Halbleiterelemente (120) ein erstes Halbleiterelement und ein zweites Halbleiterelement umfasst, die elektrisch miteinander verbunden sind.

9. Thermoelektrisches Modul (100) nach Anspruch 8, wobei das erste Halbleiterelement ein P-leitendes Halbleiterelement ist und das zweite Halbleiterelement ein N-leitendes Halbleiterelement ist.

10. Thermoelektrisches Modul (100) nach Anspruch 8 oder 9, wobei ein Volumen des zweiten Halbleiterelements größer als das des ersten Halbleiterelements ist.

11. Thermoelektrisches Modul (100) nach einem der Ansprüche 1 bis 10, wobei ein Volumen des ersten Substrats (110a) und ein Volumen des zweiten Substrats (110b) voneinander verschieden sind.

12. Thermoelektrisches Modul (100) nach einem der Ansprüche 1 bis 11, ferner umfassend Elektrodenschichten auf dem ersten Substrat (110a) und dem zweiten Substrat (110b).

13. Wärmeumwandlungsvorrichtung, die ein thermoelektrisches Modul (100) nach Anspruch 3 aufweist.

## Revendications

1. Module thermoélectrique (100), comprenant :
un premier substrat (110a) et un second substrat (110b) disposés l'un face à l'autre ;
un élément thermoélectrique unitaire disposé dans une zone interne entre le premier substrat (110a) et le second substrat (110b) disposés l'un face à l'autre et incluant une paire d'éléments semi-conducteurs (122 ; 124) connectés électriquement l'un à l'autre ; et
au moins deux sortes de pièces d'étanchéité (132 ; 134) ayant différentes conductivités thermiques et disposées dans la zone interne, et
dans lequel les deux sortes de pièces d'étanchéité (132 ; 134) sont composées d'un isolant,
**caractérisé en ce que** le premier substrat (110a) a une première couche de Cu (114a) et une deuxième couche de Cu (116a), une première couche de substrat céramique (112a) étant interposée entre la première couche de Cu (114a) et la seconde couche de Cu (116a),
dans lequel le second substrat (110b) a une troisième couche de Cu (116b) et une quatrième couche de Cu (114b), une seconde couche de substrat céramique (112b) étant interposée entre la troisième couche de Cu (116b) et la quatrième couche de Cu (114b),
dans lequel chaque épaisseur des première et seconde couches de substrat céramique (112a, 112b) va de 0,1 à 1 mm,
dans lequel les première et quatrième couches de Cu (114a, 114b) sont chacune liées aux côtés externes du module thermoélectrique et sont formées sur les surfaces des première et seconde couches de substrat céramique (112a, 112b) et chaque épaisseur des première et quatrième couches de Cu (114a, 114b) va de 50 à 500 µm,
dans lequel les deuxième et troisième couches de Cu (116a, 116b) sont chacune liées aux côtés internes du module thermoélectrique et connectées électriquement à l'élément thermoélectrique et formées sur les surfaces des première et seconde couches de substrat céramique (112a, 112b) et chaque épaisseur des deuxième et troisième couches (116a, 116b) va de 0,01 à 0,3 mm.

2. Module thermoélectrique (100) selon la revendication 1, dans lequel les deux sortes de pièce d'étanchéité (130) comprennent : une première pièce d'étanchéité (132) en contact avec la deuxième couche de Cu (116a) et une seconde pièce d'étanchéité (134) en contact avec la troisième couche de Cu (116b) et en contact avec la première pièce d'étanchéité (132).

3. Module thermoélectrique (100) selon la revendication 2, dans lequel la première pièce d'étanchéité (132) est composée d'un matériau ayant une conductivité thermique plus faible que celle de la seconde pièce d'étanchéité (134).

4. Module thermoélectrique (100) selon la revendication 3, dans lequel un volume de la première pièce d'étanchéité (132) et un volume de la seconde pièce d'étanchéité (134) sont sensiblement identiques l'un à l'autre.

5. Module thermoélectrique (100) selon l'une quelconque des revendications 1 à 4, dans lequel le premier substrat (110a) est une zone d'absorption de chaleur.

6. Module thermoélectrique (100) selon l'une quelconque des revendications 1 à 3, dans lequel le second substrat (110b) est une zone de génération de chaleur, et un volume de la seconde pièce d'étanchéité (134) est plus grand que celui de la première pièce d'étanchéité (132).

7. Module thermoélectrique (100) selon l'une quelconque des revendications 1 à 6, dans lequel une zone du second substrat (110b) est plus large que celle du premier substrat (110a).

8. Module thermoélectrique (100) selon l'une quelconque des revendications 1 à 7, dans lequel la paire d'éléments semi-conducteurs (120) comprend un premier élément semi-conducteur et un second élément semi-conducteur connectés électriquement l'un à l'autre.

9. Module thermoélectrique (100) selon la revendication 8, dans lequel le premier élément semi-conducteur est un élément semi-conducteur du type P et le second élément semi-conducteur est un élément semi-conducteur de type N.

10. Module thermoélectrique (100) selon la revendication 8 ou 9, dans lequel un volume du second élément semi-conducteur est plus grand que celui du premier élément semi-conducteur.

11. Module thermoélectrique (100) selon l'une quelconque des revendications 1 à 10, dans lequel un volume du premier substrat (110a) et un volume du second substrat (110b) sont différents l'un de l'autre.

12. Module thermoélectrique (100) selon l'une quelconque des revendications 1 à 11, comprenant en outre des couches d'électrodes sur le premier substrat (110a) et le second substrat (110b).

13. Dispositif de conversion de chaleur incluant un module thermoélectrique (100) selon la revendication 3.
